# EUROPEAN PATENT APPLICATION

(11) **EP 4 664 133 A1**
(43) Date of publication of application: **17.12.2025**
(21) Application number: 24845975.2
(22) Date of filing: 22.07.2024
(51) Int. Cl.: G01R 31/392, G01R 31/396, G01R 31/367, G01R 31/385

(54) **BATTERY DIAGNOSTIC DEVICE AND OPERATING METHOD THEREOF**

(30) Priority: 25.07.2023 KR 20230097064
(71) Applicant: LG Energy Solution, Ltd., Seoul 07335 (KR)
(72) Inventor: KIM, Gyeong Mo, Daejeon 34122 (KR); LEE, Sang Mu, Daejeon 34122 (KR); LEE, Yong Gu, Daejeon 34122 (KR)
(74) Representative: Goddar, Heinz J.
(86) International application number: PCT/KR2024/010536
(87) International publication number: WO 2025/023673

(57) **Abstract**

A battery diagnosis apparatus according to an embodiment disclosed herein includes an information obtaining unit configured to obtain feature data of each of a plurality of battery cells and a controller configured to extract a latent variable from the feature data, perform a primary determination as to whether each of the plurality of battery cells is defective, based on a feature value corresponding to the latent variable, and perform a secondary determination as to whether each battery cell is defective, based on a result of the primary determination and a distribution of the feature value.

## Description

### CROSS-REFERENCE TO RELATED APPLICATION

This application claims priority to and the benefit of Korean Patent Application No. 10-2023-0097064 filed in the Korean Intellectual Property Office on July 25, 2023, the entire content of which is incorporated herein by reference.

### TECHNICAL FIELD

Embodiments disclosed herein relate to a battery diagnosis apparatus and an operating method thereof.

### BACKGROUND

Recently, research and development of secondary batteries have been actively performed. Herein, the secondary batteries, which are chargeable/dischargeable batteries, may include any of conventional nickel (Ni)/cadmium (Cd) batteries, Ni/metal hydride (MH) batteries, etc., and recent lithium-ion batteries. Among the secondary batteries, lithium-ion batteries have a much higher energy density than conventional Ni/Cd batteries, Ni/MH batteries, etc. Moreover, lithium-ion batteries may be manufactured to be small and lightweight, such that lithium-ion batteries have been used as a power source of mobile devices, and recently, the use of lithium-ion batteries has been extended to include their use as power sources for electric vehicles, attracting attention as next-generation energy storage media.

When a defect of a battery, such as short-circuit, negative electrode exposure, lithium precipitation, etc., occurs in a battery cell included in a battery pack, there is a risk of fire, making it necessary to early detect a defective battery cell and take action before occurrence of fire.

### SUMMARY

Embodiments disclosed herein aim to provide a battery diagnosis apparatus and an operating method thereof in which a defect of a battery cell may be early diagnosed to prevent a risk of fire.

Technical problems of the embodiments disclosed herein are not limited to the above-described technical problems, and other unmentioned technical problems would be clearly understood by one of ordinary skill in the art from the following description.

A battery diagnosis apparatus according to an embodiment disclosed herein includes an information obtaining unit configured to obtain feature data of each of a plurality of battery cells and a controller configured to extract a latent variable from the feature data, perform a primary determination as to whether each of the plurality of battery cells is defective, based on a feature value corresponding to the latent variable, and perform a secondary determination as to whether each of the plurality of battery cells is defective, based on a result of the primary determination and adistribution of the feature value.

According to an embodiment, the controller may be further configured to obtain a distribution chart indicating the distribution of the feature value and perform the secondary determination as to whether each of the plurality of battery cells is defective, based on a position of each of the plurality of battery cells on the distribution chart.

According to an embodiment, the controller may be further configured to perform the secondary determination to determine that a battey cell is defective, when the cell has a distance of at least a first level from other battery cells determined as being normal on the distribution chart among battery cells determined as being normal in the primary determination result; and
perform the secondary determination to determine that battery cells are normal, when the battery cells having a density of at least a second level with other battery cells determined as being defective on the distribution chart among battery cells determined as being defective in the primary determination result.

According to an embodiment, the controller may be further configured to input the feature data to a pre-trained auto encoder to extract the latent variable.

According to an embodiment, the auto encoder may be configured to learn a process of receiving feature data regarding a normal cell and extracting the latent variable.

According to an embodiment, the controller may be further configured to input the feature value to a pre-trained model to obtain the primary determination result.

According to an embodiment, the feature data may include differential capacity data (dQ/dV) of the battery.

According to an embodiment, the information obtaining unit may be further configured to obtain the feature data during a low-current period of an initial stage of activation of the plurality of battery cells.

A battery diagnosis method according to an embodiment disclosed herein includes obtaining feature data of each of a plurality of battery cells, extracting a latent variable from the feature data, performing a primary determination as to whether each of the plurality of battery cells is defective, based on a feature value corresponding to the latent variable, and performing a secondary determination as to whether each of the plurality of battery cells is defective, based on a result of the primary determination and a distribution of the feature value.

According to an embodiment, performing the secondary determination as to whether each of the plurality of battery cells is defective may further include obtaining a distribution chart indicating the distribution of the feature value and performing the secondary determination to determine whether each of the plurality of battery cells is defective, based on a position of each of the plurality of battery cells on the distribution chart.

According to an embodiment, performing the secondary determination as to whether each of the plurality of battery cells is defective, based on a position of each of the plurality of battery cells on the distribution chart may include performing the secondary determination to determinethat a battery cell is defective, when the battery cell has a distance of at least a first level from other battery cells determined as being normal on the distribution chart among battery cells determined as being normal in the primary determination result and performing the secondary determination to determe that battery cells are normal, when the battery cells having a density of at least a second level with other battery cells determined as being defective on the distribution chart among battery cells determined as being defective in the primary determination result.

According to an embodiment, the extracting of the latent variable may include inputting the feature data to a pre-trained auto encoder to extract the latent variable.

The battery diagnosis apparatus and the operating method thereof according to an embodiment disclosed herein may diagnose whether a battery cell is defective at an initial activation stage. Thus, by preventing leakage of the defective battery cell, a risk of fire may be prevented and reliability for a customer may be secured.

The battery diagnosis apparatus and the operating method thereof according to an embodiment disclosed herein may prevent fire from occurring due to a defect of a battery cell, thereby preventing productivity from degrading due to fire and improving safety.

In addition, various effects identified directly or indirectly through this document may be provided.

### DESCRIPTION OF DRAWINGS

FIG. 1 is a block diagram showing a structure of a general battery pack, according to an embodiment disclosed herein.
FIG. 2 is a block diagram of a battery diagnosis apparatus according to an embodiment disclosed herein.
FIG. 3 shows an example of a data flow of a battery diagnosis apparatus, according to an embodiment disclosed herein.
FIG. 4 is a diagram showing an example of a primary determination result and a distribution chart, according to an embodiment disclosed herein.
FIG. 5 is a flowchart of a battery diagnosis method according to an embodiment disclosed herein.
FIG. 6 is a flowchart for describing a secondary determination process according to an embodiment disclosed herein.
FIG. 7 is a block diagram showing a hardware configuration of a computing system for performing an operating method of a battery management apparatus, according to an embodiment disclosed herein.

### DETAILED DESCRIPTION

Hereinafter, various embodiments of the inventive concept will be described with reference to the accompanying drawings. However, the description is not intended to limit the present disclosure to particular embodiments, and it should be construed as including various modifications, equivalents, and/or alternatives according to the embodiments of the present disclosure.

Herein, it is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

Each component (e.g., a module or a program) of the components described herein may include a single entity or multiple entities. According to various embodiments, one or more of the components may be omitted, or one or more other components may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

As used herein, the term "module" or "...unit" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments of the present disclosure may be implemented as software (e.g., a program or application) including one or more instructions that are stored in a storage medium (e.g., a memory) that is readable by a machine. For example, a processor of the machine may invoke at least one of the one or more instructions stored in the storage medium, and execute it, with or without using one or more other components under the control of the processor. This may enable the machine to operate to perform at least one function according to the at least one called instruction. The one or more instructions may include a code generated by a compiler or a code executable by an interpreter. A machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

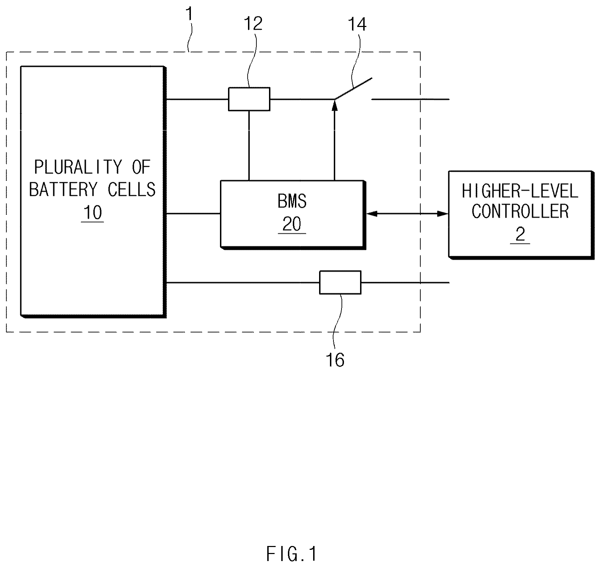

FIG. 1 is a block diagram showing a structure of a general battery pack, according to an embodiment of the present disclosure.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a plurality of battery cells 10 that include one or more battery cells that are chargeable/dischargeable, a switching unit 14 serially connected to positive (+) terminal sides or negative (-) terminal sides of the plurality of battery cells 10 to control a charging/discharging current flow of the plurality of battery cells 10, and a battery management system 20 for control and management to prevent over-charging and over-discharging by monitoring voltage, current, temperature, etc., of the battery pack 1. The battery pack 1 may include the plurality of battery cells 10, the sensor 12, the switching unit 14, and the battery management system 20 provided in plural.

Herein, as the switching unit 14 which is an element for controlling a current flow for charging or discharging of the plurality of battery cells 10, for example, at least one relay, magnetic contactor, etc., may be used according to specifications of the battery pack 1.

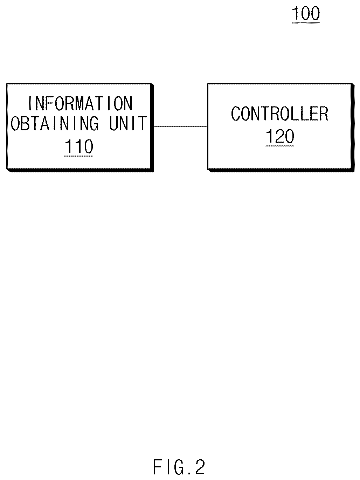

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the plurality of battery cells 10 to monitor the state of each battery cell 10. According to an embodiment, the battery management system 20 may include a battery management apparatus 100 of FIG. 2. According to another embodiment, the battery management system 20 may be different from the battery management apparatus 100 of FIG. 2. That is, the battery management apparatus 100 of FIG. 2 may be included in the battery pack 1 and may be configured as another device outside the battery pack 1. The following operation of the battery management apparatus 100 may also be performed in various devices such as not only a battery management system (BMS) in a vehicle, but also a server, a cloud, a charger, a charger/discharger, etc.

The higher-level controller 2 may transmit a control signal regarding the plurality of battery cells 10 to the battery management system 20. Thus, the battery management system 20 may also be controlled in terms of an operation thereof based on a signal applied from the higher-level controller 2.

FIG. 2 is a block diagram of a battery diagnosis apparatus according to an embodiment disclosed herein.

Referring to FIG. 2, the battery diagnosis apparatus 100 according to an embodiment disclosed herein may include an information obtaining unit 110 and a controller 120. Depending on an embodiment, the battery diagnosis apparatus 100 may be included in the battery management system 20 of FIG. 1 or may be another device that is different from the battery management system 20 of FIG. 1.

The battery diagnosis apparatus 100 may analyze feature data of a battery cell included in the battery pack 1 to determine whether each battery cell is defective. The battery diagnosis apparatus 100 may improve the accuracy of determination of whether the battery cell is defective, by absolutely or relatively analyzing the feature data of each battery cell.

The information obtaining unit 110 may obtain the feature data of each battery cell. The feature data of the battery cell may include data of various types related to an operation of the battery cell. For example, the feature data of the battery cell may include voltage data, current data, temperature data, capacity data, etc. According to an embodiment, the feature data of the battery cell may include differential capacity data (dQ/dV). Herein, the capacity of the battery cell may mean a charge amount of the battery cell. The information obtaining unit 110 may further obtain data such as a state of health (SOH), a state of charge (SOC), etc., of each battery cell.

According to an embodiment, the information obtaining unit 110 may obtain the feature data of the battery cell during a low-current period of an initial stage of activation of the battery cell. When a fire occurs in the battery cell, other cells around the fire-impacted cell may be damaged, thus degrading productivity and causing safety issues. The battery diagnosis apparatus 100 may obtain battery data during the low-current period of the initial stage of activation of the battery cell to diagnose a defect of the battery cell. That is, the battery diagnosis apparatus 100 may rapidly detect a defect through diagnosis at the initial stage of activation and detect the defect while lowering a risk of fire by obtaining data during the low-current period.

For example, the battery diagnosis apparatus 100 may perform battery defect diagnosis at a verification stage before the sale and after completion of manufacturing of the battery cell. For example, the battery diagnosis apparatus 100 may connect low-current equipment to a manufacturing-completed battery cell and activate the battery cell by supplying low current thereto, and obtain feature data of the battery cell during a low-current supply period, thereby performing a defect diagnosis. The low-current equipment has a higher detection precision such as voltage, current, etc., than general chargers/dischargers, allowing accurate defect determination.

As such, the battery diagnosis apparatus 100 may diagnose a defect of the battery cell at the initial stage of activation of the battery cell to prevent a fire accident. The battery diagnosis apparatus 100 may prevent leakage or supply of a defective cell by detecting the defect of the battery cell at the initial stage of activation of the battery cell, thereby securing reliability for the customer and preventing productivity from degrading due to fire and improving safety by preventing fire from occurring.

The controller 120 may extract a latent variable from the feature data of the battery cell. The latent variable may be a variable that implicitly contains the characteristics of the feature data of the battery cell. According to an embodiment, the controller 120 may extract the latent variable by inputting the feature data to a pre-trained auto encoder. There may be at least one latent variable extracted by the auto encoder.

The auto encoder may mean a neural network trained to output the same data as input data. The auto encoder may learn a process of extracting the characteristics of the input data and restoring the input data. The auto encoder may extract characteristics (latent variables) including the feature of the input data through the learning process.

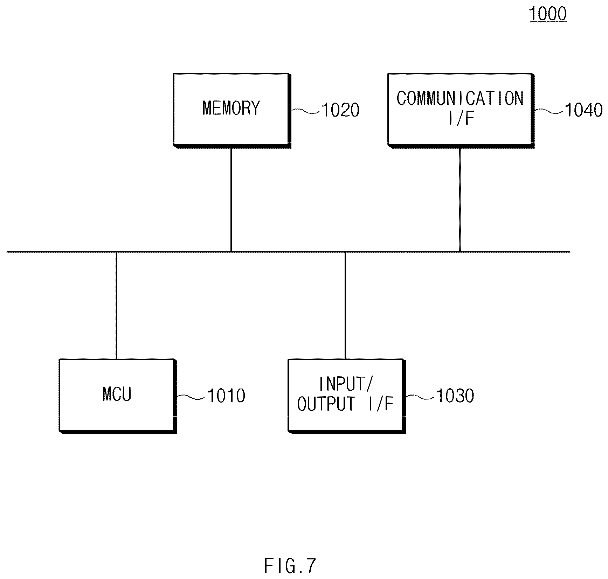

According to an embodiment, the auto encoder may learn a process of receiving feature data of normal cells and extracting a latent variable. Data regarding the normal cells may be stored in a database (not shown) or a memory (e.g., the memory 1020 of FIG. 7) and may be used as training data in the learning of the auto encoder. More specifically, the auto encoder may learn a process of extracting a latent variable during a process of restoring feature data for input normal cells.

The controller 120 may primarily determine whether each battery cell is defective, based on a feature value corresponding to the latent variable. The feature value corresponding to the latent variable may mean a value expressing the feature data with respect to the latent variable. For example, the feature value may be expressed as a vector regarding latent variables.

As the auto encoder learns data regarding normal cells and extracts a latent variable, when feature data regarding a defective cell is input to the pre-trained auto encoder, the controller 120 may primarily determine whether the battery cell is defective, based on a fact that a feature value of a latent variable of a defective cell shows a different tendency than a feature value of a normal cell. For example, the controller 120 may set a reference value for feature values for determining whether the battery cell is defective or not, and determine whether the battery cell is defective, by comparing the feature value with the reference value. In this case, the reference value may be statistically and experimentally set. The controller 120 may store a primary determination result of whether each battery cell is defective, and the primary determination result may include a defect determination result of each battery cell. That is, the controller 120 may temporarily determine whether each battery cell is defective, through primary determination.

A defect determination method using a general auto encoder may determine a defect by using a reconstruction error indicating an error between input data of the auto encoder and an error of restored input data. However, the auto encoder according to embodiments disclosed herein may be quite different from existing defect determination methods with respect to using a latent variable inherently extracted in a process of restoring input data by the auto encoder rather than using an error with restored data.

According to an embodiment, the controller 120 may generate a primary determination result by inputting a feature value to a pre-trained model. The pre-trained model may include trained models such as machine learning (ML), deep learning (DL), reinforcement learning, etc. The pre-trained model may include, but are not limited to, models such as a convolutional neural network (CNN), a region with convolutional neural network (R-CNN), a fully convolutional neural network (FCNN), etc., such as GoogleNet, AlexNet, a VGG Network, etc.

The pre-trained model may learn a process of determining whether the battery cell is defective, from the feature value. That is, the pre-trained model may be a model having a feature value as an input and a defect determination result as an output. For example, the pre-trained model may be a classifier model based on machine learning.

The controller 120 may secondarily determine whether each battery cell is defective, based on the primary determination result and a distribution of the feature value. The secondary determination result may be a final determination of whether each battery cell is defective.

The controller 120 may secondarily determine whether the battery cell is defective, by considering both the defect determination result of the battery cell in primary determination and the distribution of the feature value. The primary determination result and the secondary determination result of each battery cell may not be the same as each other, and for example, even a battery cell determined as being normal in the primary determination may be determined as being defective in the secondary determination.

According to an embodiment, the controller 120 may obtain a distribution chart indicating a distribution of the feature value. For example, the controller 120 may obtain the distribution chart by displaying the distribution of the feature value on a latent space having each axis as a latent variable. The controller 120 may also present the primary determination result on the distribution chart. That is, the controller 120 may make an expression such that a normal cell and a defective cell may be distinguished from each other as the primary determination result on the distribution chart. For example, the controller 120 may express the defective cell and the normal cell with different colors, shapes, symbols, etc., on the distribution chart.

According to an embodiment, the controller 120 may secondarily determine whether each battery cell is defective, based on a position of each battery cell on the distribution chart. Each battery cell has a feature value corresponding to feature data, such that a position of the feature value on the distribution chart may be interpreted as being the same as the position of the battery cell. For example, the controller 120 may secondarily determine, as being defective, even a cell determined as being normal as the primary determination result, when the cell has a different tendency than general normal cells. In another example, the controller 120 may determine, as normal cells, even cells determined as being defective as the primary determination result, when the cells have similar tendencies. As such, the controller 120 may relatively determine whether a battery cell is defective, based on a relationship between a position of each battery cell and other battery cells.

According to an embodiment, the controller 120 may secondarily determine, as being defective, a cell having a distance of at least a first level from other cells determined as being normal on the distribution chart among cells determined as being normal as the primary determination result. The distance between cells may include an Euclidean distance on the distribution chart. For example, a distance between a specific cell and other cells may be an average of Euclidean distances between the cell and the other cells. The first level may be statistically and experimentally determined based on center distances of cells determined as being normal as the primary determination result. For example, the first level may be determined based on an average of the center distances of the cells determined as being normal as the primary determination result.

That is, when even a normal cell as the primary determination result is far from other cells determined as being normal, the controller 120 may secondarily determine the cell as being defective by predicting that the cell has a different feature than other cells and has a high possibility of being defective.

According to an embodiment, the controller 120 may secondarily determine, as being normal, cells having a density of at least a second level with other cells determined as being defective on the distribution chart among cells determined as being defective as the primary determination result. The density may be determined based on the number of cells included in a space of a specific size, etc. The second level may be statistically and experimentally determined based on the density of cells on the distribution chart. For example, the second level may be determined based on an average density of cells determined as being normal and an average density of cells determined as being defective, as the primary determination result. For example, the controller 120 may secondarily determine, as being normal, cells having a density higher than an average density of cells determined as being normal among cells determined as being defective as the primary determination result.

That is, when a density of cells determined as being defective is high, it may mean that features of the cells are similar to each other and thus the cells have a higher possibility of being normal than being defective, such that the controller 120 may secondarily determine the cells as being normal.

When the battery cell is identified as defective as the secondary determination result, the controller 120 may provide information about a defective battery cell to a user. For example, the controller 120 may provide information about a defective battery cell to a user terminal through a communication unit (not shown) and provide the information about the defective battery cell through a display provided in a vehicle, a charger, etc.

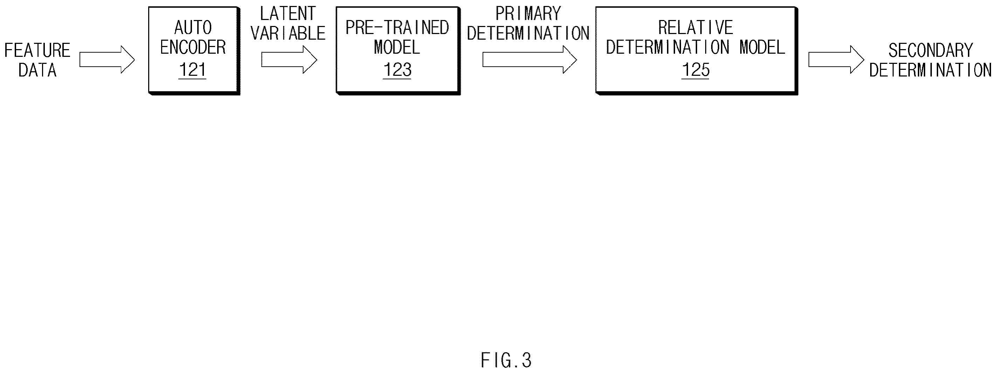

FIG. 3 shows an example of a determining process of a battery diagnosis apparatus, according to an embodiment disclosed herein.

Referring to FIG. 3, the battery diagnosis apparatus 100 may extract a latent variable from feature data of a battery cell to primarily determine whether each battery cell is defective, and perform a secondary determination using a primary determination result.

First, the battery diagnosis apparatus 100 may input the feature data of the battery cell to the auto encoder 121. The auto encoder 121 may extract a latent variable from the feature data. There may be at least one latent variable extracted by the auto encoder 121.

The battery diagnosis apparatus 100 may input the extracted latent variable to a pre-trained model 123. The pre-trained model 123 may generate the primary determination result for each battery cell based on a feature value corresponding to the latent variable. The pre-trained model may learn a process of determining, from the feature value, whether the battery cell is defective, and the primary determination result may include whether each battery cell is defective.

The battery diagnosis apparatus 100 may perform secondary determination using the primary determination result. The battery diagnosis apparatus 100 may input the primary determination result and a distribution chart of the feature value to a relative determination model 125 to secondarily determine whether each battery cell is defective. The relative determination model 125 may be a neural network model or a rule-based model. When the relative determination model 125 is a neural network model, the relative determination model 125 may be different from the pre-trained model 123 that performs primary determination.

The auto encoder 121, the pre-trained model 123, and the relative determination model 125 may be parts of the controller 120 or may be external components physically separated from the controller 120.

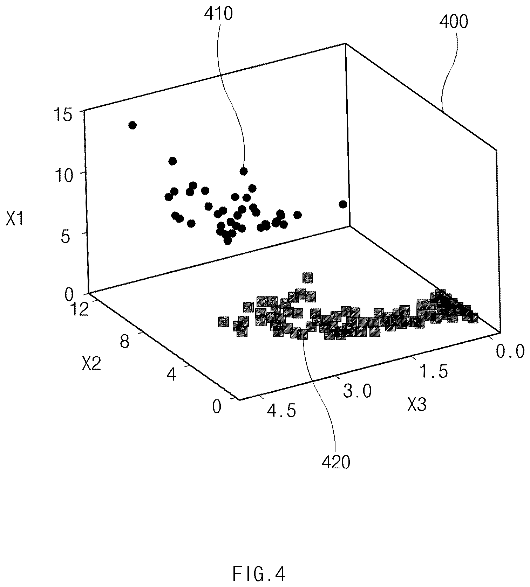

FIG. 4 is a diagram showing an example of a primary determination result and a distribution chart, according to an embodiment disclosed herein.

Referring to FIG. 4, the controller 120 may obtain a distribution chart 400 indicating the distribution of a feature value of each battery cell.

The controller 120 may perform primary determination for each battery cell based on the feature value. The controller 120 may make an expression to identify the primary determination result on the distribution chart 400. For example, the controller 120 may express cells 410 determined as being defective as the primary determination result as circles and cells 420 determined as being normal as the primary determination result as rectangles to distinguish defective cells from normal cells, as shown in FIG. 4.

In FIG. 4, x1, x2, and x3 respectively corresponding to axes x, y, and z may mean latent variables extracted by the auto encoder 121. In another example, the auto encoder 121 may extract four or more latent variables, and the controller 120 may select some (X1, X2, X3) among the extracted latent variables to obtain a distribution chart.

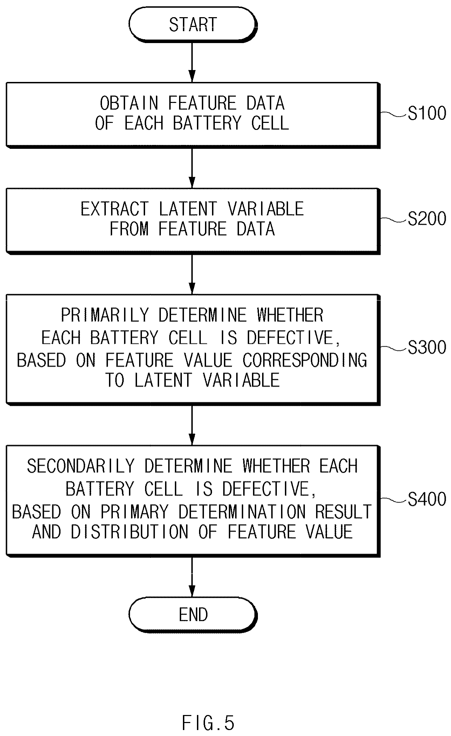

FIG. 5 is a flowchart of a battery diagnosis method according to an embodiment disclosed herein.

Referring to FIG. 5, a battery diagnosis method may include operation S100 of obtaining feature data of each battery cell, operation S200 of extracting a latent variable from the feature data, operation S300 of primarily determining whether each battery cell is defective, based on a feature value corresponding to the latent variable, and operation S400 of secondarily determining whether each battery cell is defective, based on the primary determination result and distribution of the feature value.

In operation S100, the information obtaining unit 110 may obtain the feature data of each battery cell. In an embodiment, the feature data of the battery cell may include differential capacity data (dQ/dV).

In operation S200, the controller 120 may extract a latent variable from the feature data of the battery cell. In an embodiment, the controller 120 may input feature data of the battery cell to an auto encoder to extract the latent variable.

In operation S300, the controller 120 may primarily determine whether each battery cell is defective, based on the feature value. In an embodiment, the controller 120 may input the feature value of each battery cell to a pre-trained model to obtain the primary determination result. That is, the controller 120 may perform absolute determination based on the feature value for each battery cell.

In operation S400, the controller 120 may secondarily determine whether each battery cell is defective, based on the primary determination result and distribution of the feature value. That is, the controller 120 may perform a relative determination based on the distribution of the feature value of each battery cell.

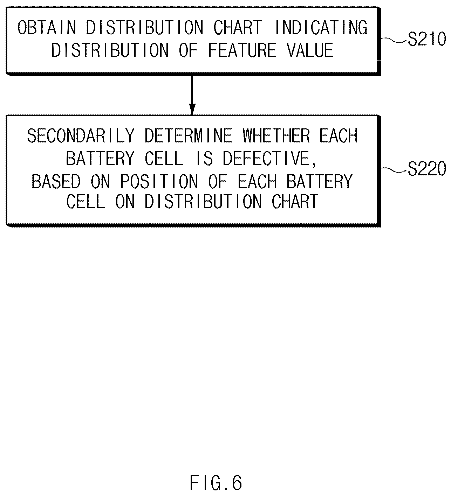

FIG. 6 is a flowchart for describing a secondary determination process according to an embodiment disclosed herein.

Referring to FIG. 6, operation S200 may include operation S210 of obtaining a distribution chart indicating the distribution of the feature value and operation S220 of secondarily determining whether each battery cell is defective, based on a position of each battery cell on the distribution chart.

In operation S210, the controller 120 may obtain the distribution chart indicating the distribution of the feature value. For example, the controller 120 may obtain a multidimensional latent space having latent variables as each axis and display a position of a feature value on the latent space to obtain the distribution chart.

In operation S220, the controller 120 may perform a secondary determination, based on a position of each battery cell on the distribution chart. In an embodiment, the controller 120 may secondarily determine, as being defective, a cell having a distance of at least the first level from other cells determined as being normal on the distribution chart among cells determined as being normal as the primary determination result, and secondarily determine, as being normal, a cell having a density of at least the second level with other cells determined as being defective on the distribution chart among cells determined as being defective as the primary determination result.

FIG. 7 is a block diagram showing a hardware configuration of a computing system for performing an operating method of a battery management apparatus, according to an embodiment disclosed herein.

Referring to FIG. 7, a computing system 1000 according to an embodiment disclosed herein may include a microcontroller unit (MCU) 1010, a memory 1020, an input/output interface (I/F) 1030, and a communication I/F 1040.

The MCU 1010 may be a processor that executes various programs (e.g., a battery cell feature data collection program, a latent variable extraction program, a distribution generation program, a battery cell diagnosis program, etc.) stored in the memory 1020, processes various information including feature data, latent variables, etc., of the battery cell through these programs, and executes the above-described functions of the controller included in the battery management apparatus shown in FIG. 2.

The memory 1020 may store various programs such as a battery cell feature data collection program, a latent variable extraction program, a distribution generation program, a battery cell diagnosis program, etc. Moreover, the memory 1020 may store various information such as feature data, a latent variable, etc., of the battery cell.

The memory 1020 may be provided in plural, depending on a need. The memory 1020 may be a volatile or nonvolatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., with the MCU 1010.

The communication I/F 1040, which is a component capable of transmitting and receiving various data to and from a server, may be various types of devices capable of supporting wired or wireless communication. For example, the battery management apparatus may transmit and receive various information including SOC, OCV, parameter, etc., of the battery cell from an external server separately provided through the communication I/F 1040.

As such, a computer program according to an embodiment disclosed herein may be recorded in the memory 1020 and processed by the MCU 1010, thus being implemented as a module that performs functions shown in FIG. 2.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

## Claims

1. A battery diagnosis apparatus comprising:
an information obtaining unit configured to obtain feature data of each of a plurality of battery cells; and
a controller configured to:
extract a latent variable from the feature data;
perform a primary determination as to whether each of the plurality of battery cells is defective, based on a feature value corresponding to the latent variable; and
perform a secondary determination as to whether each of the plurality of battery cells is defective, based on a result of the primary determination and a distribution of the feature value.

2. The battery diagnosis apparatus of claim 1, wherein the controller is further configured to:
obtain a distribution chart indicating the distribution of the feature value; and
perform the secondary determination as to whether each of the plurality of battery cells is defective, based on a position of each battery cell on the distribution chart.

3. The battery diagnosis apparatus of claim 2, wherein the controller is further configured to:
perform the secondary determination to determine that a battery cell is defective, when the battery cell has a distance of at least a first level from other battery cells determined as being normal on the distribution chart among battery cells determined as being normal in the primary determination result; and
perform the secondary determination to determine that battery cells are normal, when the battery cells have a density of at least a second level with other battery cells determined as being defective on the distribution chart among battery cells determined as being defective in the primary determination result.

4. The battery diagnosis apparatus of claim 1, wherein the controller is further configured to input the feature data to a pre-trained auto encoder to extract the latent variable.

5. The battery diagnosis apparatus of claim 4, wherein the auto encoder is configured to learn a process of receiving feature data regarding a normal cell and extracting the latent variable.

6. The battery diagnosis apparatus of claim 1, wherein the controller is further configured to input the feature value to a pre-trained model to obtain the primary determination result.

7. The battery diagnosis apparatus of claim 1, wherein the feature data comprises differential capacity data (dQ/dV) of the battery.

8. The battery diagnosis apparatus of claim 1, wherein the information obtaining unit is further configured to obtain the feature data during a low-current period of an initial stage of activation of each of the plurality of battery cells.

9. A battery diagnosis method comprising:
obtaining feature data of each of a plurality of battery cells;
extracting a latent variable from the feature data;
performing a primary determination as to whether each of the plurality of battery cells is defective, based on a feature value corresponding to the latent variable; and
performing a secondary determination as to whether each of the plurality of battery cells is defective, based on a result of the primary determination and a distribution of the feature value.

10. The battery diagnosis method of claim 9, wherein performing the secondary determination of whether each of the plurality of battery cells is defective further comprises:
obtaining a distribution chart indicating the distribution of the feature value; and
performing the secondary determination as to whether each of the plurality of battery cells is defective, based on a position of each of the plurality of battery cells on the distribution chart.

11. The battery diagnosis method of claim 10, wherein performing the secondary determination of whether each of the plurality of battery cells is defective, based on a position of each of the plurality of battery cells on the distribution chart comprises:
performing the secondary determination to determine that a battery cell is defective, when the battery cell has a distance of at least a first level from other battery cells determined as being normal on the distribution chart among battery cells determined as being normal in the primary determination result; and
performing the secondary determination to determine that battery cells are normal, when the battery cells have a density of at least a second level with other battery cells determined as being defective on the distribution chart among battery cells determined as being defective in the primary determination result.

12. The battery diagnosis method of claim 9, wherein extracting of the latent variable comprises inputting the feature data to a pre-trained auto encoder to extract the latent variable.
